(19) Europäisches Patentamt
European Patent Office
Office européen des brevets

(11) **EP 4 472 080 A1**

(12) **EUROPEAN PATENT APPLICATION**

(43) Date of publication:
**04.12.2024 Bulletin 2024/49**

(21) Application number: **24173771.7**

(22) Date of filing: **02.05.2024**

(51) International Patent Classification (IPC):
**H03M 1/06** *(2006.01)*    **H03M 1/08** *(2006.01)*
**H03M 1/46** *(2006.01)*

(52) Cooperative Patent Classification (CPC):
**H03M 1/466; H03M 1/0678; H03M 1/0863;
H03M 1/462**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.05.2023 US 202318326042**

(71) Applicant: **INTEL Corporation
Santa Clara, CA 95054 (US)**

(72) Inventors:
• **MAERKOVICH, Sophia
34670 Haifa (IL)**
• **ZUR, Sarit
49063 Petah-Tikva (IL)**
• **AVRAHAM, Oren Ezra
5405220 Givat Shmuel (IL)**

(74) Representative: **Viering, Jentschura & Partner
mbB
Patent- und Rechtsanwälte
Am Brauhaus 8
01099 Dresden (DE)**

(54) **SUCCESSIVE APPROXIMATION REGISTER ANALOG-TO-DIGITAL CONVERTER**

(57) A circuit comprising: an analog-to-digital converter configured to generate a digital signal based on a received input voltage and a received reference voltage; a capacitor array; and a switching network configured to switch each capacitor of the capacitor array between a first conductor connected to a supply voltage source, and a second conductor connected to the reference voltage; wherein the analog-to-digital converter comprises a logic configured to control the switching network to selectively switch between the first conductor and the second conductor based on the generated digital signal.

FIG. 2

EP 4 472 080 A1

## Description

### TECHNICAL FIELD

Various embodiments relate generally to analog-to-digital converters and implementations and uses of same.

### BACKGROUND

Successive approximation register (SAR) analog-to-digital converters (ADC) are a type of analog-to-digital converters that convert an analog signal into a digital signal.

SAR ADCs have the advantage that they utilize very little power. However, SAR ADCs introduce nonlinear memory effects due to large current draws from a reference rail. This occurs because the previous bit's conversion causes the reference voltage to drop. This in turn distorts the next bit's conversion. This degrades the overall performance of the SAR ADC.

### BRIEF DESCRIPTION OF THE DRAWINGS

FIG. 1 is an exemplary representation of a known SAR ADC circuit.
FIG. 2 is an exemplary representation of an SAR ADC circuit according to this disclosure.
FIG. 3 is an exemplary embodiment of a first stage of boosting a reference voltage.
FIG. 4 is an exemplary embodiment of a second stage of boosting a reference voltage.
FIG. 5 is an exemplary representation of a method of converting an analog signal into a digital signal using the circuit of FIG. 2.
FIG. 6 depicts a method for converting an analog signal into a digital signal.

### DETAILED DESCRIPTION

The following detailed description refers to the accompanying drawings that show, by way of illustration, specific details and embodiments in which the invention may be practiced.

The following detailed description refers to the accompanying drawings. The same reference numbers may be used in different drawings to identify the same or similar elements. In the following description, for purposes of explanation and not limitation, specific details are set forth such as particular structures, architectures, interfaces, techniques, etc. in order to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail. For the purposes of the present document, the phrases "A or B" and "A/B" mean (A), (B), or (A and B).

While the present teachings are described in conjunction with various embodiments and examples, it is not intended that the present teachings be limited to such embodiments. On the contrary, the present teachings encompass various alternatives and equivalents, as will be appreciated by those of skill in the art. All statements herein reciting principles, aspects, and embodiments of this disclosure, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

As used herein, the terms "first", "second", and so forth are not intended to imply sequential ordering, but rather are intended to distinguish one element from another, unless explicitly stated. Similarly, sequential ordering of method steps does not imply a sequential order of their execution, unless explicitly stated.

As used herein, the term "exemplary" means "serving as an example, instance, or illustration". Any embodiment or design described herein as "exemplary" is not necessarily to be construed as preferred or advantageous over other embodiments or designs.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (e.g., a non-transitory computer-readable medium) in which data or information can be stored for retrieval. References to "memory" included herein may thus be understood as referring to volatile or nonvolatile memory, including random access memory (RAM), read-only memory (ROM), flash memory, solid-state storage, magnetic tape, hard disk drive, optical drive, 3D XPointTM, among others, or any combination thereof. Registers, shift registers, processor registers, data buffers, among others, are also embraced herein by the term memory. The term "software" refers to any type of executable instruction, including firmware.

To prevent nonlinear memory effects from occurring on SAR ADCs, attempts to reduce voltage drops on the reference rail have been made. To this end, large current buffers or very large capacitors on the reference rail have been employed. This has the disadvantage of causing a current consumption penalty and consuming considerable space. Alternatively, limitations on the bandwidth/backoff tradeoff have been employed. However, in this method, the level of a high-bandwidth signal has to be set considerably below the ADC full-scale power to avoid distortions, thus bringing the signal closer to the ADC's noise floor. This decreases the signal-to-noise ratio.

In accordance with this disclosure, one way to compensate for the voltage drop that occurs when the ADC draws large amounts of current from a voltage source is to provide a capacitor array with a switching network configured to switch one or more capacitors of the capacitor array between a conductor connected to a supply voltage source and a conductor connected to the reference rail. This enables the voltage drop from the previous cycle to be compensated before the next cycle of the analog-to-digital conversion process of the SAR ADC begins. This solution is more space-efficient and energy-efficient than previous solutions, and it imposes fewer limitations on the bandwidth/backoff tradeoff.

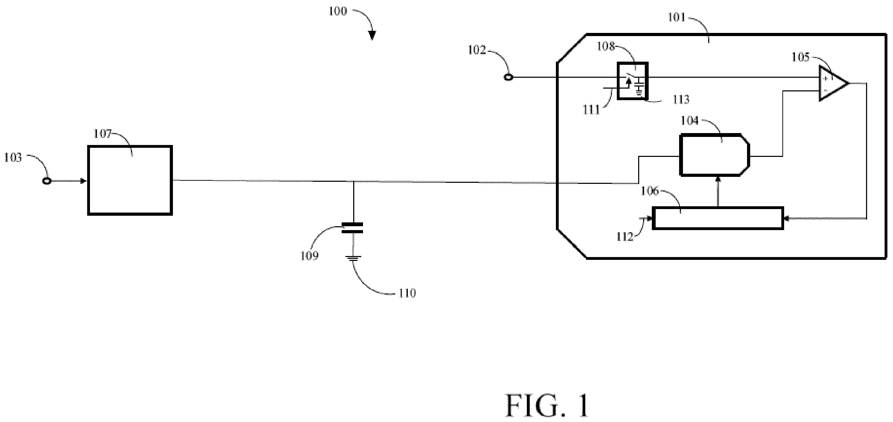

FIG. 1 shows an exemplary representation of a known circuit 100. In this example, circuit 100 includes analog-to-digital converter (ADC) 101, input voltage source 102, reference voltage source 103, and fixed capacitor (CAP) 109. The reference voltage source is connected to low dropout regulator (LDO) 107, and the capacitor is connected to ground 110. It is expressly noted that the term "ground", as used herein, refers to a reference voltage that may be zero or non-zero. The term "ground", rather than "reference voltage", is used herein for clarity to distinguish from the reference voltage corresponding to the "reference voltage source 103" in FIG. 1.

ADC 101 includes a sample and hold (S/H) circuit 108 connected to the input voltage source 102. S/H circuit 108 has the function of sampling an input voltage from input voltage source 102. S/H circuit 108 may be connected to clock 111 for sampling the input voltage at certain points in time. S/H circuit 108 also includes capacitor 113. Capacitor 113 stores the analog input voltage for a short time.

ADC 101 further includes digital-to-analog converter (DAC) 104. DAC receives a reference voltage from the reference voltage source.

ADC 101 further includes successive approximation register (SAR) logic 106, which is configured to provide DAC 104 with a digital signal and perform other functions described hereinafter. SAR logic 106 is connected to clock 112. Clock 112 may control the timing for the internal SAR loop.

ADC 101 further includes comparator 105, which receives an output voltage from DAC 104 and a sample of the input voltage from S/H circuit 108. Comparator 105 compares the sample of the input voltage with the sample of the output voltage of DAC 104 and generates an output depending on the larger of the sample of the input voltage and the output voltage of DAC 104. SAR logic 106 controls DAC 104 by providing DAC 104 with a binary output based on the result from comparator 105.

Returning to CAP 109, CAP 109 charges from LDO 107 and voltage source 103 and discharges into DAC 104. When DAC 104 draws a current from the reference voltage source, the voltage between LDO 107 and DAC 104 drops, and CAP 109 discharges into DAC 104. The period when DAC 104 does not draw current from the reference voltage source provides a recovery period for CAP 109. During this period, CAP 109 recharges.

This voltage drop, as described above, introduces a nonlinear memory effect due to large current draws from the reference voltage source. That is, the previous cycle may cause the reference voltage for the next cycle (e.g. the voltage between LDO 107 and DAC 104) to drop and hence be lower than desired. This distorts the next cycle, since DAC 104 generates its output in part from this reference voltage. Known circuit 100 uses CAP 109 to reduce the reference voltage drops that occur with each new cycle. However, to sufficiently mitigate the reference voltage drop with a single capacitor, a very large capacitor would be required. Adding a very large capacitor, however, would consume significant current and space.

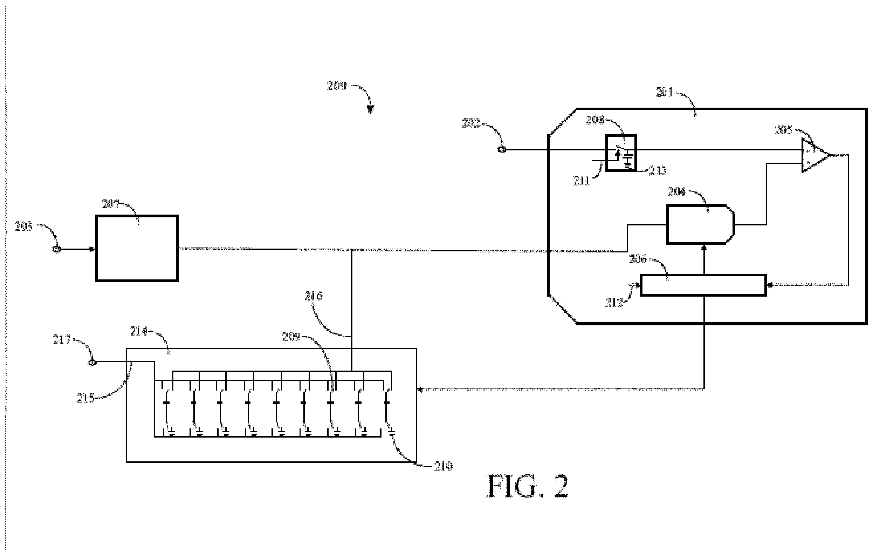

FIG. 2 shows an exemplary representation of circuit 200 of the present disclosure. In FIG. 2, circuit 200 includes ADC 201 and capacitor array 209 that is connected to supply voltage source 217 through first conductor 215 or connected to reference voltage source 203 through second conductor 216. In FIG. 2, when the capacitors of capacitor array 209 are connected to reference voltage source 203, the capacitors may be connected to reference voltage source 203 with upper terminals and to ground 210 with lower terminals (the terms "upper" and "lower" are described relative to the orientation in FIG. 2 and are used to denote opposing terminals of the capacitor. The person skilled in the art will appreciate that the switching array may be configured in various alternative arrangements, such as when ground 210 is connected to the upper terminal and reference voltage source 203 is connected to the lower terminal). Circuit 200 further includes switching network 214, configured to switch each capacitor of capacitor array 209 between first conductor 215 and second conductor 216. ADC 201 includes logic 206 configured to control switching network 214. A person skilled in the art will appreciate that a switch generally refers to an electrical component that connects two electrical connections or terminates a connection between the two electrical connections. For example, when the switch is open, the electrical connections between two points are terminated. Alternatively, when the switch is closed, the electrical connections between two points are connected. The switch may include, for example, one or more bipolar junction transistors or one or more metal-oxide-semiconductor field effect transistors (MOSFETs). In FIG. 2, the capacitors of capacitor array 209 may be connected in parallel. For capacitors connected in parallel, the total capacitance is the sum of the individual capacitances of each capacitor. The capacitors may have identical capacitances or one or more of the capacitors may have a capacitance different from another capacitor of the capacitor array 209. ADC 201 is configured to generate a digital signal based on a received input voltage and a received boosted reference voltage (e.g., wherein the boosted reference voltage is the reference voltage from LDO 207 that has been diminished (e.g. dropped) by ADC 204's current draw and increased by discharge of one or more capacitors of switching network 214). Logic 206 is further configured to provide an output to ADC 201. ADC 201 uses the output in the process of generating the digital signal based on the received input voltage and the received reference voltage.

Circuit 200 may further include reference voltage source 203 configured to provide the reference voltage. The reference voltage source may be connected to LDO 207.

Circuit 200 may include input voltage source 202 configured to provide the input voltage to be converted to a digital output.

In FIG. 2, ADC 201 may include S/H circuit 208. S/H circuit 208 may be connected to clock 211 for sampling the input voltage at certain points in time. S/H circuit 208 may also include capacitor 213. Capacitor 213 may store the analog input voltage for a short time.

In FIG. 2, ADC 201 of circuit 200 may include DAC 204 connected to second conductor 216. DAC 204 may be configured to use a voltage at second conductor 216 to generate an output voltage based on the output of logic 206.

In FIG. 2, ADC 201 may further include comparator 205 which may be configured to receive the output voltage from DAC 204, receive the input voltage from S/H circuit 208, compare the input voltage to the output voltage, and output to logic 206 a comparison voltage based on a comparison of a sample of the input voltage with the output voltage of DAC 204. In FIG. 2, comparator 205 may compare the input voltage from S/H circuit 208 with the output voltage from DAC 204 and, depending on which one is higher, may output either a high voltage or a low voltage. In some configurations, comparator 205 may provide a first value if the input voltage is higher than the output voltage and a second value if the input voltage is lower than the output voltage. In FIG. 2, S/H circuit 208 may be coupled to one input terminal of comparator 205. In some configurations, DAC 204 may be coupled to another input terminal of comparator 205. In some configurations, one of the input terminals may be a positive input terminal and another of the input terminals may be a negative input terminal. In FIG. 2, S/H circuit 208 may be coupled to the positive input terminal. In some configurations, DAC 204 may be coupled to the negative terminal of comparator 205. In some configurations, comparator 205 may be a high-gain amplifier (including but not limited to operational amplifier), integrated circuit, configuration of transistors or another component. In some configurations, comparator 205 may be a dynamic comparator, which is based on a clock signal. It should be appreciated that the dynamic comparator may also help to reduce consumption associated with SAR ADC 201.

In FIG. 2, logic 206 may be configured to control switching network 214 to selectively switch between first conductor 215 and second conductor 216 based on the comparison voltage. Logic 206 may include a SAR logic. In some configurations, the control signal provided by logic 206 to switching network 214 may be in a digital form, for which case an additional controller for operation of the switching network may be implemented (not pictured). In some configurations, the control signal provided by logic 206 to switching network 214 may be in an analog form, such that the analog signal output opens or closes one or more switches of the switching network. The control signal provided by logic 206 to DAC 204 may be in a digital form.

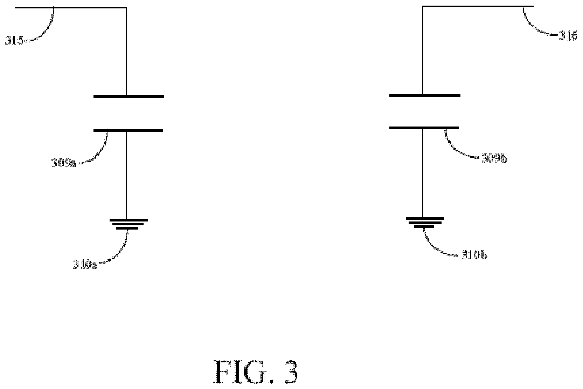

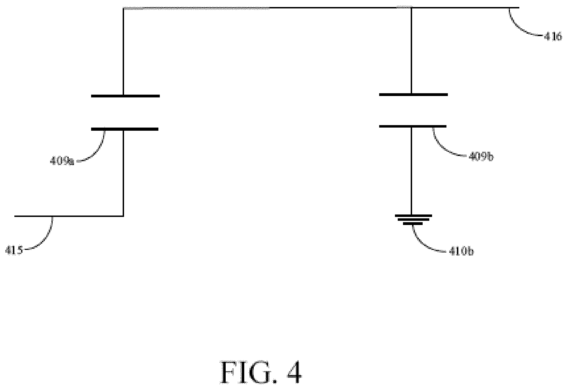

Turning to FIG. 3 with reference to FIG. 2, an example of the first stage of the boosting reference voltage is provided. It should be appreciated that the electric operations shown in FIGs. 3 and 4 are simplified. In the illustrated example, it is shown that first capacitor 309a is being charged because first capacitor 309a is connected to supply voltage source 217 (not shown) via its upper terminal through first conductor 315, and first capacitor 309a is connected to ground 3 10a via the lower terminal. In FIG. 3, it is shown that second capacitor 309b is not being charged at this stage, as this is not needed at this stage. Second 309b capacitor may be connected to second conductor 316 via its upper terminal, and may be connected to ground 310b via its lower terminal.

Turning to FIG. 4 with reference to FIG. 2, an example of the second stage of boosting the reference voltage is provided. FIG. 4 shows first capacitor 409a now riding the supply voltage source 217. First capacitor 409a may be connected to supply voltage source 217 through first conductor 415 with the lower terminal and may be connected to second conductor 416 with the upper terminal. Second capacitor 409b may also be connected to second conductor 416 with its upper terminal and connected to ground 410b with its lower terminal. FIG. 4 shows second capacitor 409b now being charged from the first capacitor 409a through second conductor 416. FIG. 4 shows the first capacitor also current boosting the reference voltage through the second conductor 416.

For the second stage of boosting the reference voltage the following relationship is true:

$$V_{supply} * C_1 - \left(V_{ref_2} - V_{supply}\right) * C_1 = \left(V_{ref_2} - V_{ref_1}\right) * C_2 \qquad (1)$$

where $V_{supply}$ is the supply voltage source; $C_1$ is the capacitance of first capacitor 409a of FIG. 4; $V_{ref1}$ is the reference voltage during the first stage, when no boosting of the reference voltage takes place, this is the voltage that exists in second conductor 316 as the result of a voltage from reference voltage source 203; $V_{ref2}$ is the boosting reference voltage, it is the reference voltage portion that is configured to boost the reference voltage during the second stage, $V_{ref2}$ will add to the reference voltage from reference voltage source 203 to form the boosted reference voltage; and $C_2$ is the capacitance of second capacitor 409b of FIG. 4.

Rearranging we get a formula expressing a boosting portion of the boosted reference voltage that may be received by DAC 204, $V_{ref2}$ :

$$V_{ref_2} = \frac{2 * V_{supply} * C_1 + V_{ref_1} * C_2}{C_1 + C_2} \qquad (2)$$

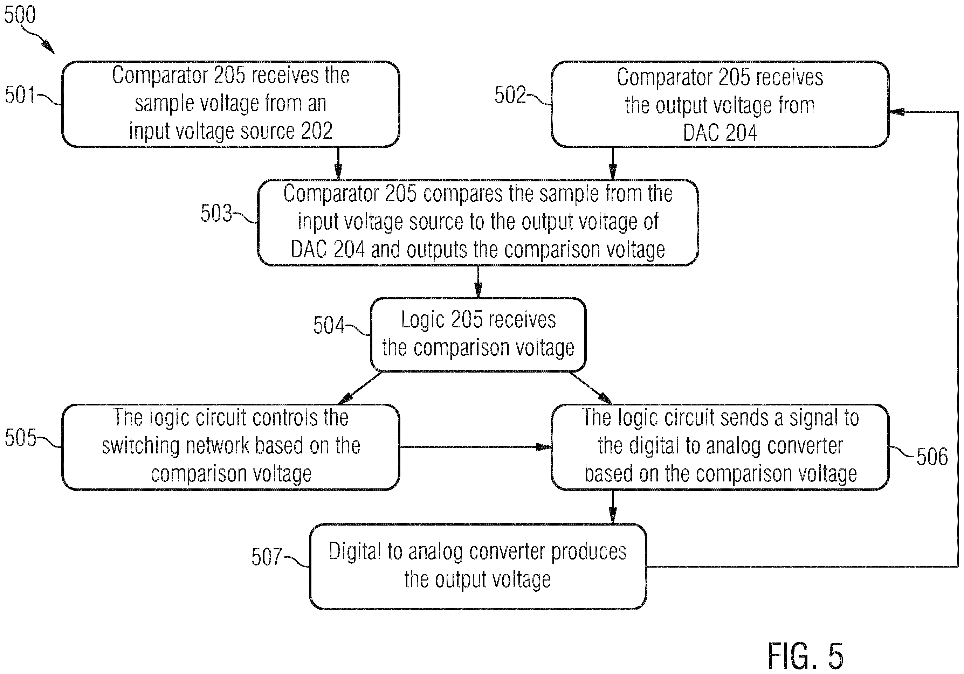

Referring to FIG. 5 with further reference to FIG. 2, a method for converting the analog signal to the digital signal using the circuit disclosed in FIG. 2 is presented. In FIG. 2, the analog signal may be converted into the digital signal by processing a sample in a loop. N-loop iterations may be needed to obtain an N-bit code. The value of N may be any integer that is greater than 0. In operation, comparator 205 may receive 501 the input voltage from input voltage source 202 by means of S/H circuit 208 and may receive 502 the output voltage from DAC 204. Comparator 205 may compare 503 the input voltage against the output voltage and may provide 503 the comparison voltage. Logic 206 may receive 504 the comparison voltage. Logic 206 may record the comparison voltage and may determine 506 the digital signal to input into DAC 204 for the next cycle of the N-cycle loop based on the comparison voltage. Based on the digital signal from logic 206, DAC 204 may generate 507 an output voltage for the next cycle. At this point, the next cycle begins. However, before DAC 204 receives the reference voltage to be used in the next cycle, logic 206 may current boost 505 the reference voltage by controlling switching network 214 to switch from first conductor 215, connected to supply voltage source 217, to second conductor 216, connected to reference voltage 203. The capacitors of capacitor array 209 may have been connected to supply voltage source 217 and may have been charging. When the capacitors are switched to the second conductor 216, they may discharge into second conductor 216, thus current boosting the reference voltage. One capacitor may be switched from first conductor 215 to second conductor 216 or more than one capacitor may be switched. The number of capacitors switched from first conductor 215 to second conductor 216 may be determined by the amount of current boosting needed.

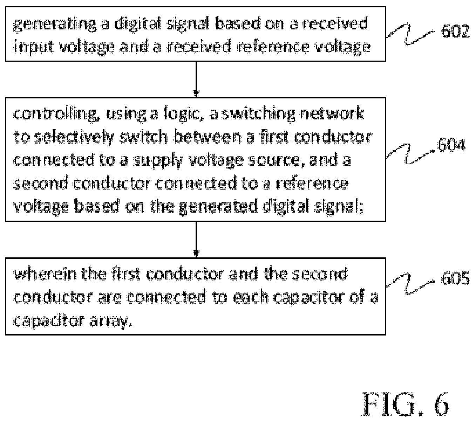

FIG. 6 depicts a method for converting an analog signal into a digital signal according to an aspect of the disclosure. The method includes generating a digital signal based on a received input voltage and a received reference voltage 602; controlling, using a logic, a switching network to selectively switch between a first conductor connected to a supply voltage source, and a second conductor connected to a reference voltage based on the generated digital signal 604; wherein the first conductor and the second conductor are connected to each capacitor of a capacitor array 606. The method may further include generating an output voltage based on a voltage at the second conductor and an output of the logic. The method may further include outputting to the logic a comparison voltage based on a comparison of a sample of the input voltage with the output voltage 608.

In accordance with the present disclosure, there is provided a circuit including an analog-to-digital converter, a capacitor array, and a switching network.

The analog-to-digital converter is configured to generate a digital signal based on a received input voltage and a received reference voltage. The analog-to-digital converter includes a logic. In some configurations, the analog-to-digital converter may include a successive-approximation-register analog-to-digital converter. In some configurations, the analog-to-digital converter may include a direct type analog-to-digital converter. The logic may include a successive-approximation-register logic.

The switching network is configured to switch each capacitor of the capacitor array between a first conductor and a second conductor. The first conductor is connected to a supply voltage source. The second conductor is connected to the reference voltage. The first and/or the second conductors may include metal wires. At least one wire may include, for example, at least one of copper, gold, silver, aluminum, nickel or tungsten/wolfram metals. The switching network may include an electrical switch. The logic is configured to control the switching network to selectively switch between the first conductor and the second conductor based on the generated digital signal.

In some configurations, the circuit may further include a digital-to-analog converter. The digital-to-analog converter may be connected to the second conductor. The digital-to-analog converter may be configured to generate an output voltage based on a voltage at the second conductor and an output of the logic. The digital-to-analog converter may include a weighted resistor digital-to-analog converter, an R-2R ladder digital-to-analog converter, or any other known method of digital-to-analog conversion. The output of the logic may include a digital code. The digital code may include a binary code. The digital code may be an N-symbol code.

In some configurations, the circuit may further include a comparator. In some configurations, the comparator may include a non-inverting comparator. In some configurations, the comparator may include an inverting comparator. In some configurations, the comparator may be a high-gain amplifier (including but not limited to operational amplifier), integrated circuit, configuration of transistors, or another type of comparator. In some configurations, the comparator may be a dynamic comparator, which is based on a clock signal. It should be appreciated that the dynamic comparator may also help reduce power consumption associated with SAR ADC 201. The comparator may be configured to output to the logic a comparison voltage based on a comparison of a sample of the input voltage with the output voltage of the digital-to-analog converter. In some configurations, the comparator generates a first value if the input voltage is higher than the output voltage and a second value if the input voltage is lower than the output voltage. In some configurations, the logic may be configured to control the switching network to selectively switch between the first conductor and the second conductor based on the comparison voltage. In some configurations, the logic may be configured to generate an output to control the switching network based on the comparison voltage and a look-up table. In this manner, the look-up table may include one or more previous digital output values and/or one or more analog output values (e.g. one or more values associated with a last DAC or ADC conversion), which may be associated with a voltage drop, and a related voltage drop to compensate. The look-up table may include instructions (e.g. output) to control the switching network to correspondingly charge one or more switches of the switching network.

In some configurations, the circuit may further include a memory. The memory may include any device, combination of devices, circuitry, and the like that is capable of storing, accessing, organizing and/or retrieving data. Non-limiting examples include ROM, data stored on a microchip, or cache memory. The memory may be configured to store the look-up table.

In some configurations, the logic may further include a hardware logic. The hardware logic may be configured to generate an output to control the switching network based on the comparison voltage. In other configurations, the logic may be configured to control the switching network to change a voltage at the second conductor based on the comparison voltage.

In some configurations, the capacitor array may include a plurality of capacitors, wherein the plurality of capacitors may be connected in parallel. In some configurations, some of the capacitors of the capacitor array may be connected in parallel. In some configurations, the capacitor array may include two or more capacitors. In some configurations, according to structure, the capacitors may include fixed, variable, or trimmer capacitors. In some configurations, according to polarization, any one or more of the capacitors may be polarized. Alternatively, any one or more of the capacitors may be unpolarized. In some configurations, the capacitors may have ceramic, film, power film, oxide layer on metal, mica, glass, paper, air, $SF_6$, vacuum dielectrics. In some configurations, the capacitors may include supercapacitors. In some configurations, the capacitors may have identical capacitances. In some configurations, one or more of the capacitors may have a capacitance different from another capacitor of the capacitor array. In some configurations, the capacitors of the capacitor array may be switched synchronously with each other. In some configurations, the capacitors may be switched asynchronously relative to one other.

In some configurations, the circuit may be configured as a successive approximation converter.

In some configurations, the circuit may further include a reference voltage source configured to provide the reference voltage. In these configurations, the reference voltage source may include a low-dropout regulator.

In some configurations, the circuit may further include an input voltage source. The input voltage source may be configured to provide the input voltage. In these configurations, the circuit may include a sample and hold circuit connected to the input voltage source. The sample and hold circuit may be configured to sample the input voltage and to output the sample of the input voltage.

In some configurations, each capacitor of the capacitor array may include a first terminal having a first polarity and a second terminal having a second polarity, opposite the first polarity. In these configurations, the switching network may include a first switching network. In these configurations, the first switching network may be configured to selectively switch the first terminal of each capacitor of the capacitor array between the first conductor and the second conductor. In some configurations, the circuit may further include a second switching network. In these configurations, the second switching network may be configured to selectively switch the second terminal of each capacitor of the capacitor array between the first conductor and a further reference voltage.

In some configurations, the analog-to-digital converter may be connected to an input voltage source. In some configurations, the analog-to-digital converter may be connected to a reference voltage source.

In some configurations, the analog-to-digital converter may be configured to convert each analog voltage of a plurality of analog voltages to bit signal.

In some configurations, the analog-to-digital converter may be configured to decrease nonlinear memory effect introduced by the each reference voltage drop caused by each converted analog signal.

Example 1 may include a circuit including: an analog-to-digital converter configured to generate a digital signal based on a received input voltage and a received reference voltage;

a capacitor array; and a switching network configured to switch each capacitor of the capacitor array between a first conductor connected to a supply voltage source, and a second conductor connected to the reference voltage; wherein the analog-to-digital converter includes a logic configured to control the switching network to selectively switch between the first conductor and the second conductor based on the generated digital signal.

Example 2 may include the circuit of example 1, wherein the circuit further includes a digital-to-analog converter, connected to the second conductor, and configured to generate an output voltage based on a voltage at the second conductor and an output of the logic.

Example 3 may include the circuit of any of examples 1 to 2, further including a comparator, configured to output to the logic a comparison voltage based on a comparison of a sample of the input voltage with the output voltage of the digital-to-analog converter.

Example 4 may include the circuit of any of examples 1 to 3, wherein the logic is configured to control the switching network to selectively switch between the first conductor and the second conductor based on the comparison voltage.

Example 5 may include the circuit of any of example 1 to 4, wherein the logic is configured to generate an output to control the switching network based on the comparison voltage and a look-up table.

Example 6 may include the circuit of any of examples 1 to 5, further including a memory, configured to store the look-up table.

Example 7 may include the circuit of any of examples 1 to 6, wherein the logic further includes a hardware logic, and wherein the hardware logic is configured to generate an output to control the switching network based on the comparison voltage.

Example 8 may include the circuit of any of examples 1 to 7, wherein the logic is configured to control the switching network to change a voltage at the second conductor based on the comparison voltage.

Example 9 may include the circuit of any of examples 1 to 8, wherein the capacitor array includes a plurality of capacitors, and wherein the plurality of capacitors is connected in parallel.

Example 10 may include the circuit of any of examples 1 to 9, wherein the circuit is configured as a successive approximation converter.

Example 11 may include the circuit of any of examples 1 to 10, further including a reference voltage source configured to provide the reference voltage, wherein the reference voltage source includes a low-dropout regulator.

Example 12 may include the circuit of any of examples 1 to 11, further including: an input voltage source configured to provide the input voltage; and a sample and hold circuit connected to the input voltage source and configured to sample the input voltage and to output the sample of the input voltage.

Example 13 may include the circuit of any of examples 1 to 12, wherein each capacitor of the capacitor array includes a first terminal having a first polarity and a second terminal having a second polarity, opposite the first polarity; wherein the switching network is a first switching network, and wherein the first switching network is configured to selectively switch the first terminal of each capacitor of the capacitor array between the first conductor and the second conductor.

Example 14 may include the circuit of any of examples 1 to 13, further including a second switching network, configured to selectively switch the second terminal of each capacitor of the capacitor array between the first conductor and a further reference voltage.

Example 15 may include the circuit of any of examples 1 to 14, wherein the analog-to-digital converter is connected to an input voltage source and a reference voltage source.

Example 16 may include a method for converting an analog signal into a digital signal, the method including generating a digital signal based on a received input voltage and a received reference voltage; controlling, using a logic, a switching network to selectively switch between a first conductor connected to a supply voltage source, and a second conductor connected to a reference voltage based on the generated digital signal; wherein the first conductor and the second conductor are connected to each capacitor of a capacitor array.

Example 17 may include the method of example 16, including generating an output voltage based on a voltage at the second conductor and an output of the logic.

Example 18 may include the method of example 17, including outputting to the logic a comparison voltage based on a comparison of a sample of the input voltage with the output voltage.

Example 19 may include the method of example 18, including controlling the switching network to selectively switch between the first conductor and the second conductor based on the comparison voltage.

Example 20 may include a non-transitory computer-readable medium having instructions stored thereon, wherein the instructions, when executed by a logic, cause the logic to generate a digital signal based on a received input voltage and a received reference voltage; control a switching network to selectively switch between a first conductor connected to a supply voltage source, and a second conductor connected to a reference voltage based on the generated digital signal; wherein the first conductor and the second conductor are connected to each capacitor of a capacitor array.

Example 21 may include the non-transitory computer-readable medium of example 20, wherein the instructions if executed, cause generation of an output voltage based on a voltage at the second conductor and an output of the logic.

Example 22 may include the non-transitory computer-readable medium of example 21, wherein the instructions if executed, cause outputting to the logic a comparison voltage based on a comparison of a sample of the input voltage with the output voltage.

Example 23 may include the non-transitory computer-readable medium of example 22, wherein the instructions if executed, cause the switching network to selectively switch between the first conductor and the second conductor based on the comparison voltage.

Example 24 may include a circuit including a means for generating a digital signal based on a received input voltage and a received reference voltage; a means for controlling, using a logic, a switching network to selectively switch each capacitor of a capacitor array between a first conductor connected to a supply voltage source and a second conductor connected to the reference voltage based on the generated digital signal.

Example 25 may include the circuit of example 24, the example 25 may include a means for generating an output voltage based on a voltage at the second conductor and an output of the logic.

Example 26 may include the circuit of example 25, the example 25 may include a means for outputting to the logic a comparison voltage based on a comparison of a sample of the input voltage with the output voltage.

Example 27 may include the circuit of example 26, the example 27 may include a means for controlling the switching network to selectively switch between the first conductor and the second conductor based on the comparison voltage.

While the above descriptions and connected figures may depict components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

**Claims**

1. A circuit comprising:

 an analog-to-digital converter configured to generate a digital signal based on a received input voltage and a received reference voltage;
 a capacitor array; and
 a switching network configured to switch a capacitor of the capacitor array between a first conductor connected to a supply voltage source, and a second conductor connected to the reference voltage;
 wherein the analog-to-digital converter comprises a logic configured to control the switching network to selectively switch between the first conductor and the second conductor based on the generated digital signal.

2. The circuit of claim 1,

 wherein the circuit further comprises a digital-to-analog converter, connected to the second conductor, and configured to generate an output voltage based on a voltage at the second conductor and an output of the logic; and preferably
 further comprising a comparator, configured to output to the logic a comparison voltage based on a comparison of a sample of the input voltage with the output voltage of the digital-to-analog converter.

3. The circuit of any one of claims 1 or 2,

 wherein the logic is configured to control the switching network to selectively switch between the first conductor and the second conductor based on the comparison voltage; and
 preferably wherein the logic is configured to generate an output to control the switching network based on the comparison voltage and a look-up table.

4. The circuit of any one of claims 1 to 3, further comprising:
 a memory, configured to store the look-up table.

5. The circuit of any one of claims 1 to 4,
 wherein the logic further comprises a hardware logic, and wherein the hardware logic is configured to generate an output to control the switching network based on the comparison voltage.

6. The circuit of any one of claims 2 to 5,
 wherein the logic is configured to control the switching network to change a voltage at the second conductor based on the comparison voltage.

7. The circuit of any one of claims 1 to 6,
 wherein the capacitor array comprises a plurality of capacitors, and wherein the plurality of capacitors is connected in parallel.

8. The circuit of any one of claims 1 to 7,
 wherein the circuit is configured as a successive approximation converter.

9. The circuit of any one of claims 3 to 8, further comprising:
 a reference voltage source configured to provide the reference voltage, wherein the reference voltage source comprises a low-dropout regulator.

10. The circuit of any one of claims 2 to 9, further comprising:

 an input voltage source configured to provide the input voltage; and
 a sample and hold circuit connected to the input voltage source and configured to sample the input voltage and to output the sample of the input voltage.

**11.** The circuit of any one of claims 1 to 10,

wherein each capacitor of the capacitor array comprises a first terminal having a first polarity and a second terminal having a second polarity, opposite the first polarity; wherein the switching network is a first switching network, and wherein the first switching network is configured to selectively switch the first terminal of each capacitor of the capacitor array between the first conductor and the second conductor; and
preferably further comprising a second switching network, configured to selectively switch the second terminal of each capacitor of the capacitor array between the first conductor and a further reference voltage.

**12.** The circuit of any one of claims 1 to 11,

wherein the analog-to-digital converter is connected to an input voltage source and a reference voltage source; or
wherein the analog-to-digital converter is configured to convert each analog voltage of a plurality of analog voltages to bit signal; or
wherein the analog-to-digital converter is configured to decrease nonlinear memory effect introduced by the each reference voltage drop caused by each converted analog signal.

**13.** A method for converting an analog signal into a digital signal, comprising:

generating a digital signal based on a received input voltage and a received reference voltage; controlling, using a logic, a switching network to selectively switch between a first conductor connected to a supply voltage source, and a second conductor connected to a reference voltage based on the generated digital signal;
wherein the first conductor and the second conductor are connected to a capacitor of a capacitor array.

**14.** The method of claim 13, further comprising:
generating an output voltage based on a voltage at the second conductor and an output of the logic.

**15.** The method of claim 14, further comprising:
outputting to the logic a comparison voltage based on a comparison of a sample of the input voltage with the output voltage.

FIG. 1

FIG. 2

FIG. 3

FIG. 4

FIG. 5

EP 4 472 080 A1

generating a digital signal based on a received input voltage and a received reference voltage — 602

↓

controlling, using a logic, a switching network to selectively switch between a first conductor connected to a supply voltage source, and a second conductor connected to a reference voltage based on the generated digital signal; — 604

↓

wherein the first conductor and the second conductor are connected to each capacitor of a capacitor array. — 605

FIG. 6

Europäisches
Patentamt

European
Patent Office

Office européen
des brevets

# EUROPEAN SEARCH REPORT

**Application Number**

EP 24 17 3771

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/207518 A1 (LIU HAO [US] ET AL) 23 July 2015 (2015-07-23) * figures 2A-2B * * paragraphs [0001] - [0043] * | 1-15 | INV. H03M1/06 H03M1/08 H03M1/46 |
| X | US 9 935 643 B1 (CHANG NICK C [US] ET AL) 3 April 2018 (2018-04-03) * column 1, line 1 - column 10, line 3 * * figures 1-8 * | 1-9, 12-15 | |
| X | Iniyavan Elumalai: "A Capacitance-Based Reference Scheme for a 14b-Linear, 100 MS/s SAR-Assisted Pipeline ADC", , 21 August 2012 (2012-08-21), XP055281565, Retrieved from the Internet: URL:http://repository.tudelft.nl/islandora /object/uuid:8b94e22b-cd51-407c-af86-9c238 9f20e4c/datastream/OBJ/download [retrieved on 2016-06-17] * page 38 - page 49 * * figures 4-7,4-8,4-9 * | 1,2,5-9, 12-15 | |
| X | US 9 154 151 B1 (LEONG MUN FOOK [MY]) 6 October 2015 (2015-10-06) * figures 1-4 * * column 1, line 1 - column 14, line 39 * | 1,2, 5-10, 12-15 | TECHNICAL FIELDS SEARCHED (IPC) H03M |
| X | US 9 223 332 B1 (HIMMELBAUER WOLFGANG [US] ET AL) 29 December 2015 (2015-12-29) * figures 1-10 * * column 1, line 1 - column 10, line 43 * | 1,2, 5-10, 12-15 | |

-/--

The present search report has been drawn up for all claims

| Place of search | Date of completion of the search | Examiner |
|---|---|---|
| The Hague | 18 October 2024 | Jespers, Michaël |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 17 3771

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Anonymous: "Field-programmable gate array - Wikipedia", , 23 May 2023 (2023-05-23), pages 1-16, XP093216098, Retrieved from the Internet: URL:https://en.wikipedia.org/w/index.php?title=Field-programmable_gate_array&oldid=1156568921 * page 4 * ----- | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 18 October 2024 | Jespers, Michaël |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons
 
& : member of the same patent family, corresponding
　　document

EPO FORM 1503 03.82 (P04C01)

## ANNEX TO THE EUROPEAN SEARCH REPORT
## ON EUROPEAN PATENT APPLICATION NO.

EP 24 17 3771

This annex lists the patent family members relating to the patent documents cited in  the above-mentioned European search report.
The members are as contained in the European Patent Office EDP file on
The European Patent Office is in no way liable for these particulars which are merely given for the purpose of information.

18-10-2024

| Patent document cited in search report | | Publication date | Patent family member(s) | | Publication date |
|---|---|---|---|---|---|
| US 2015207518 | A1 | 23-07-2015 | US | 2015207518 A1 | 23-07-2015 |
| | | | US | 2017111052 A1 | 20-04-2017 |
| US 9935643 | B1 | 03-04-2018 | NONE | | |
| US 9154151 | B1 | 06-10-2015 | NONE | | |
| US 9223332 | B1 | 29-12-2015 | NONE | | |

EPO FORM P0459

For more details about this annex : see Official Journal of the European Patent Office, No. 12/82